# EUROPÄISCHE PATENTSCHRIFT

(11) **EP 3 287 217 B1**
(45) Veröffentlichungstag und Bekanntmachung des Hinweises auf die Patenterteilung: **10.04.2024**
(21) Anmeldenummer: 17185219.7
(22) Anmeldetag: 08.08.2017
(51) Int. Cl.: B23C 3/00, B23Q 15/013

(54) **VERFAHREN UND VORRICHTUNG ZUM AUFBRINGEN EINER OBERFLÄCHENSTRUKTURIERUNG AUF EINEM WERKSTÜCK AN EINER WERKZEUGMASCHINE**
METHOD AND DEVICE FOR APPLYING A STRUCTURING WITH A MACHINE TOOL TO THE SURFACE OF A WORKPIECE
PROCÉDÉ ET DISPOSITIF D'APPLICATION AVEC UNE MACHINE-OUTIL D'UNE STRUCTURE DE SURFACE SUR UNE PIÈCE D'USINAGE

(30) Priorität: 08.08.2016 DE 102016214697
(43) Veröffentlichungstag der Anmeldung: 28.02.2018
(73) Patentinhaber: DMG MORI Ultrasonic Lasertec GmbH, 55758 Stipshausen (DE)
(72) Erfinder: Ketelaer, Jens, 65205 Wiesbaden (DE)
(74) Vertreter: MERH-IP Matias Erny Reichl Hoffmann Patentanwälte PartG mbB

(56) Entgegenhaltungen:
- EP-A1- 2 946 859
- DE-A1-102010 048 638
- DE-A1-102012 002 140
- DE-A1-102013 103 843

## Beschreibung

Die vorliegende Erfindung betrifft ein Verfahren zum Aufbringen einer Oberflächenstrukturierung auf eine Oberfläche eines Werkstücks an einer Werkzeugmaschine. Des Weiteren betrifft die vorliegende Erfindung eine Werkzeugmaschine, auf dieser das vorgenannte Verfahren ausgeführt werden kann. Ferner betrifft die vorliegende Erfindung ein Computerprogramm-Produkt, mit diesem das vorgenannte Verfahren ausgeführt werden kann.

### HINTERGRUND DER ERFINDUNG

Aus der DE 10 2012 002 140 B4 ist ein gattungsgemäßes Verfahren, insbesondere Planfräsverfahren, zum Aufbringen einer Oberflächenstrukturierung auf einer Oberfläche eines Werkstücks bekannt. Eine derartige Oberflächenstrukturierung bzw. Markierung der Oberfläche kann beispielsweise Zierzwecken oder der Kodierung des Bauteils bzw. Werkstücks dienen, indem z.B. Bild- und/oder Textmuster auf der Oberfläche des Werkstücks aufgebracht werden.

Hierbei kann an einer Werkzeugmaschine ein Fräswerkzeug bzw. Planfräswerkzeug benutzt werden, welches z.B. eine axial hervorstehende Schneide aufweist, die nicht in der Werkzeugachse liegt und bei rotierendem Antreiben des Werkzeugs um die Werkzeugachse herum rotiert. Anders als beim einfachen Planfräsen weist das Fräswerkzeug z.B. eine Spitze, die z.B. durch eine hervorstehende Frässchneide des Fräswerkzeugs gebildet sein kann, und ggf. durch Zurückschleifen oder Demontage der übrigen Schneidenteile erzeugt werden kann.

Die Strukturierung der Oberfläche des Werkstücks erfolgt während des Planfräsprozesses, d.h. das Werkzeug (z.B. ein Schaftfräser oder ein Messerkopf, oder eine anderes Fräswerkzeug) bewegt sich in einer rotierenden Schnittbewegung stirnseitig
über ein Werkstück und wird dabei durch eine oder mehrere Maschinenachsen (Linear- und/oder Rundachsen) der Werkzeugmaschine bewegt. Die Spitze bzw. hervorstehende Schneide des um die Werkzeugachse rotierenden Fräswerkzeuges befindet sich nicht im Drehzentrum des Werkzeugs sondern weiter außen. Aus der Position der Werkzeugmitte (z.B. des sogenannten Tool-Center-Point) und des momentanen Drehwinkels des Werkzeuges kann die genaue Position der Spitze über der Werkstückoberfläche ermittelt werden.

Erfolgt nun bei auf Basis des gewünschten Musters vorgegebenen Positionen eine kurze, pulsförmige Auslenkung der Spitze axial nach vorne in Richtung der Werkzeugachse, drückt diese Werkzeugspitze einen Bildpunkt in die Werkstückoberfläche. Durch mehrfache, positionsgenaue Auslenkung lässt sich so ein beliebiges vorgegebenes Pixelmuster erzeugen (z.B. ein Bild- und/oder Textmuster).

Im aus dem Stand der Technik bekannten Verfahren gemäß DE 10 2012 002 140 B4 sind die Dimensionen des das Werkzeug aufnehmenden Werkzeugkopfes jedoch verhältnismäßig groß bereitzustellen. Das beschriebene Verfahren basiert darauf, dass ein Piezo-Stapelaktor durch eine rechteck-pulsförmige Spannung ausgelenkt wird. Da hierbei die Auslenkung der Spannung und der Länge des Piezo-Stapels direkt proportional ist, muss das Werkzeug automatisch sehr groß dimensioniert sein und hohe Leistung zw. Energie bereitgestellt werden.

Weiterhin lassen sich die erforderlichen pulsförmigen Spannungssignale nicht durch eine induktive bzw. kontaktlose Energie- bzw. Signalübertragung übertragen, da dort aufgrund der Induktivitäten stets eine Beeinflussung des Signals stattfindet. Werden niederfrequent (ca. 1 bis 5 kHz) kurze Pulssequenzen induktiv übertragen, wird das Signal aufgrund der hohen Induktivitäten nachteilig stark verzerrt, so dass das Muster bzw. die Oberflächenstrukturierung nicht in der gewünschten Bildqualität aufgebracht werden. Wenn allerdings Schleifringe zur Signalübertragung unter Kontakt verwendet werden, dann ist dies insbesondere aufgrund der Wartungsanfälligkeit aufgrund von Verschleiß und Verschmutzung in der industriellen Praxis nachteilig.

Darüber hinaus offenbart die deutsche Patentanmeldung DE 10 2013 103 843 A1 ein Verfahren zur Herstellung einer eine Beschichtung tragenden, als Gleitfläche oder Lauffläche bestimmten Werkstückoberfläche eines Werkstücks, wobei in einem erst Verfahrensschritt durch eine spanende Bearbeitung im Feinspindelverfahren eine Bohrung in das Werkstück eingebracht wird und anschliessend eine aktive Strukturierung durch eine der spanenden Bearbeitung überlagerte Schwingungsanregung mit einem Bearbeitungswerkzeug erfolgt,

Aus der deutschen Patentanmeldung DE 10 2010 048 638 A1 ist ein Ultraschallwerkzeug bekannt, bei dem ein Werkzeug relativ zu einem Werkstück eine Arbeitsbewegung ausführt, wobei die Arbeitsbewegugung von einer Vibration überlagert wird. Der EP 2 946 859 A1 beschreibt ein Verfahren und eine Vorrichtung zur ultraschallbetriebenen Werkstückherstellung.

Es ergeben sich somit in dem im Stand der Technik bekannten Verfahren Nachteile eines großen (und damit unzweckmäßig dimensionierten) Werkzeugkopfes sowie einer drahtgebunden (bzw. durch Schleifringe realisierten) Energieübertragung.

### ZUSAMMENFASSUNG DER ERFINDUNG

Im Hinblick auf die vorstehend beschriebenen Nachteile des vorbekannten Verfahrens zum Aufbringen einer Oberflächenstrukturierung auf einer Oberfläche eines Werkstücks zu vermeiden, ist es eine Aufgabe der vorliegenden Erfindung, ein verbessertes Verfahren zum Aufbringen einer Oberflächenstrukturierung auf einer Oberfläche eines Werkstücks bereitzustellen, das bei kleineren und kompakteren Dimensionierungen des Werkzeugs, Werkzeughalters bzw. Werkzeugkopfes sowie bei verbesserter Energieübertragung bzw. Signalübertragung und höherer Bildqualität des aufgebrachten Musters realisierbar ist.

Zur Lösung der vorstehend beschriebenen Aufgabe wird erfindungsgemäß ein Verfahren zum Aufbringen einer Oberflächenstrukturierung auf einer Oberfläche eines Werkstücks gemäß Anspruch 1 vorgeschlagen. Nebengeordnet werden eine Werkzeugmaschine gemäß Anspruch 10 und ein Computerprogrammprodukt gemäß Anspruch 11 vorgeschlagen. Zudem kann nebengeordnet ein Werkzeugkopf mit Demodulator bereitgestellt werden. Abhängige Ansprüche betreffen bevorzugte beispielhafte Ausführungen der Erfindung.

Der Erfindung liegt hierbei die Idee zugrunde, dass ein Steuersignal eines Verfahrens zum Aufbringen einer Oberflächenstrukturierung auf einer Oberfläche eines Werkstücks zum Antreiben eines schwingunsganregenden Aktuators an einem Werkzeugkopf einer Werkzeugmaschine nicht als direktes Nutzsignal sondern als mit dem Nutzsignal modulierten Steuersignal mit einem hochfrequenten Trägersignal an den Werkzeugkopf übertragen wird. Dies ermöglicht die Verwendung von induktiver Energieübertragung an den Werkzeugkopf, so dass der Werkzeugkopf wartungsunanfälliger und kompakter ausgestaltet werden kann.

Insbesondere kann so ein verbessertes Verfahren zum Aufbringen einer Oberflächenstrukturierung auf einer Oberfläche eines Werkstücks bereitgestellt werden, das bei kleineren und kompakteren Dimensionierungen des Werkzeugs, Werkzeughalters bzw. Werkzeugkopfes sowie bei verbesserter Energieübertragung bzw. Signalübertragung und höherer Bildqualität des aufgebrachten Musters realisierbar ist.

Gemäß einer zweckmäßigen bevorzugten Ausgestaltung der Erfindung können die das vorgegebene Muster angebenden Daten Bilddaten, insbesondere Bitmap-Bilddaten, umfassen. Dies hat den Vorteil, dass das Muster einfach und effizient vorgegeben werden kann.

Gemäß einer zweckmäßigen bevorzugten Ausgestaltung der Erfindung wird der Aktuator auf Basis des modulierten Steuersignals angetrieben. Dies hat den Vorteil, dass kleine, kompakte und zuverlässige Ultraschall-Werkzeugköpfe für das Verfahren verwendet werden können, selbst wenn diese keine Schaltung für Demodulation aufweisen.

Gemäß einer zweckmäßigen bevorzugten Ausgestaltung der Erfindung wird der Aktuator alternativ nach Demodulation des Steuersignals auf Basis des Nutzsignals angetrieben. Dies hat den Vorteil, dass die Bildqualität des aufgebrachten Musters weiter verbessert werden kann.

Gemäß einer zweckmäßigen bevorzugten Ausgestaltung der Erfindung ist das hochfrequente Trägersignal auf Basis des Nutzsignals amplitudenmoduliert und/oder frequenzmoduliert.

Gemäß einer zweckmäßigen bevorzugten Ausgestaltung der Erfindung weist das Trägersignal eine Frequenz im Ultraschallbereich auf. Die Frequenz des Trägersignals kann bevorzugt größer 10kHz, insbesondere größer 15 kHz und bevorzugt kleiner 60 kHz sein. Das Trägersignal kann bevorzugt eine im Wesentlichen sinusförmige

Gemäß einer zweckmäßigen bevorzugten Ausgestaltung der Erfindung weist die Oberflächenstrukturierung ein dem vorgegebenen Muster entsprechendes Muster auf.

Gemäß einer zweckmäßigen bevorzugten Ausgestaltung der Erfindung ist der Aktuator dazu eingerichtet, (ggf. zusätzlich zu einer Axialschwingung) eine Rotationsschwingung um die axiale Richtung des Fräswerkzeugs anzutreiben.

Gemäß einer zweckmäßigen bevorzugten Ausgestaltung der Erfindung umfasst der Aktuator ein oder mehrere Piezoelemente, insbesondere einen Stapel mehrerer plättchenförmiger Piezoelemente. So kann der Aktuator auf besonders einfache und zuverlässige Weise ausgebildet werden.

Gemäß einer zweckmäßigen bevorzugten Ausgestaltung der Erfindung wird das Werkzeug während der Vorschubbewegung entlang der Oberfläche des Werkstücks senkrecht zu einem Normalenvektor der Oberfläche des Werkstücks verfahren.

Obschon die Erfindung nicht darauf beschränkt ist, dass der Aktuator des Werkzeugkopfes mit dem demodulierten Steuersignal ohne die Komponenten des Trägersignals beaufschlagt wird, sondern das Verfahren auf besonders einfache Weise durchgeführt werden kann, indem das modulierte Steuersignal direkt an den Aktuator abgegeben wird, ist es auch möglich, z.B. aus Gründen einer gewünschten Oberflächenqualität, das Nutzsignal bzw. das demodulierte Steuersignal an den Aktuator abzugeben.

In diesem Zusammenhang wird gemäß Ausführungsbeispielen ein Werkzeugkopf für eine Werkzeugmaschine vorgeschlagen, der dazu eingerichtet ist, an einer Werkzeugaufnahme ein Fräswerkzeug mit zumindest einer vorstehenden Schneide aufzunehmen, und der einen Aktuator umfasst, der dazu eingerichtet ist, auf Grundlage des Steuersignals eine Schwingung des Fräswerkzeugs anzutreiben, wobei das Steuersignal ein hochfrequentes Trägersignal und ein das Trägersignal modulierendes Nutzsignal, das auf Grundlage von das vorgegebene Muster angebenden Daten erzeugt wird, aufweist.

Weiterhin kann der Werkzeugkopf eine Demodulationseinrichtung (z.B. einen Demodulationsschaltkreis) aufweisen, die dazu eingerichtet ist, das von der Steuervorrichtung der Werkzeugmaschine an dem Werkzeugkopf empfangene modulierte Steuersignal zu demodulieren bzw. durch Demodulation des modulierten Steuersignals das Nutzsignal (ohne bzw. im Wesentlichen ohne Komponenten des Trägersignals) zu rekonstruieren, und das demodulierte Steuersignal bzw. rekonstruierte Nutzsignal dem Aktuator zur Steuerung der Schwingung des Werkzeugs auf Grundlage des demodulierten Steuersignals bzw. rekonstruierten Nutzsignals einzugeben.

Weitere Aspekte und deren Vorteile als auch Vorteile und speziellere Ausführungsmöglichkeiten der vorstehend beschriebenen Aspekte und Merkmale werden aus den folgenden, jedoch in keinster Weise einschränkend aufzufassenden Beschreibungen und Erläuterungen zu den angehängten Figuren beschrieben.

### KURZBESCHREIBUNG DER FIGUREN

- Fig. 1: zeigt beispielhaft einen Werkzeughalter (Werkzeugkopf) in Schnittansicht, der in dem erfindungsgemäßen Verfahren gemäß Ausführungsbeispielen eingesetzt werden kann;
- Fig. 2: zeigt beispielhaft eine schematische Darstellung einer Werkzeugmaschine mit einem Werkzeughalter (Werkzeugkopf), welche in dem erfindungsgemäßen Verfahren gemäß Ausführungsbeispielen eingesetzt werden kann;
- Fig. 3A: zeigt beispielhaft ein Ablaufdiagramm eines Verfahrens des Übertragens eines Steuersignals in einem Verfahren zum Aufbringen einer Oberflächenstrukturierung auf eine Oberfläche eines Werkstücks an einer Werkzeugmaschine gemäß einem Ausführungsbeispiel;
- Fig. 3B: zeigt beispielhaft ein Ablaufdiagramm eines Verfahrens des Übertragens eines Steuersignals in einem Verfahren zum Aufbringen einer Oberflächenstrukturierung auf eine Oberfläche eines Werkstücks an einer Werkzeugmaschine gemäß einem weiteren Ausführungsbeispiel;
- Fig. 4A: zeigt beispielhaft ein Ablaufdiagramm eines Verfahrens des Empfangens eines Steuersignals und Aufbringen einer Oberflächenstrukturierung auf eine Oberfläche eines Werkstücks an einer Werkzeugmaschine gemäß einem Ausführungsbeispiel;
- Fig. 4B: zeigt beispielhaft ein Ablaufdiagramm eines Verfahrens des Empfangens eines Steuersignals und Aufbringen einer Oberflächenstrukturierung auf eine Oberfläche eines Werkstücks an einer Werkzeugmaschine gemäß einem weiteren Ausführungsbeispiel; und
- Fig. 5: zeigt beispielhaft Beispiele eines Trägersignals, eines Nutzsignals, eines amplitudenmodulierten Steuersignals und eines frequenzmodulierten Steuersignals gemäß Ausführungsbeispielen.

### DETAILLIERTE BESCHREIBUNG DER FIGUREN UND BEVORZUGTER AUSFÜHRUNGSBEISPIELE DER VORLIEGENDEN ERFINDUNG

Im Folgenden werden Beispiele bzw. Ausführungsbeispiele der vorliegenden Erfindung detailliert unter Bezugnahme auf die beigefügten Figuren beschrieben. Gleiche bzw. ähnliche Elemente in den Figuren können hierbei mit gleichen Bezugszeichen bezeichnet sein, manchmal allerdings auch mit unterschiedlichen Bezugszeichen.

Es sei hervorgehoben, dass die vorliegende Erfindung jedoch in keinster Weise auf die im Folgenden beschriebenen Ausführungsbeispiele und deren Ausführungsmerkmale begrenzt bzw. eingeschränkt ist, sondern weiterhin Modifikationen der Ausführungsbeispiele umfasst, insbesondere diejenigen, die durch Modifikationen der Merkmale der beschriebenen Beispiele bzw. durch Kombination einzelner oder mehrerer der Merkmale der beschriebenen Beispiele im Rahmen des Schutzumfanges der unabhängigen Ansprüche umfasst sind.

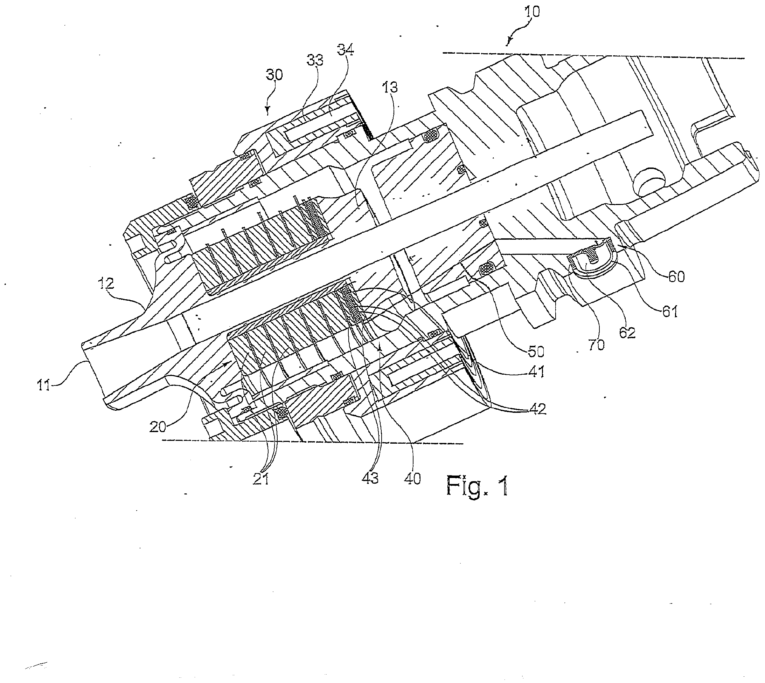

Fig. 1 zeigt einen beispielhaften Aufbau eines Werkzeughalters 10 (Werkzeugkopf), der in dem erfindungsgemäßen Verfahren eingesetzt werden kann.

An einem Ende des Werkzeughalters 10 befindet sich ein Werkzeugaufnahmeabschnitt 11 zur Aufnahme eines Werkzeugs 90 (in Fig. 1 nicht gezeigt). Im Werkzeughalter 10 sind beispielhaft mehrere, z. B. sechs lochscheibenförmige erste Piezo-Elemente 21 beispielhaft gestapelt angeordnet, die beispielhaft über einen Übertragungsabschnitt 12 mit dem Werkzeugaufnahmeabschnitt 11 verbunden sind und beispielhaft einen Ultraschallwandler 20 (UltraschallErzeuger/Aktuator) zur Umwandlung einer elektrischen Spannung in eine mechanische Schwingung (z.B. mit einer Frequenz im Ultraschallbereich) bilden.

Über den Übertragungsabschnitt 12 wird beispielhaft die mechanische Schwingung der ersten Piezo-Elemente 21 auf das Werkzeug 90 übertragen. Die ersten Piezo-Elemente 21 können beispielsweise als Piezokeramikscheiben mit dazwischen angebrachten Elektroden ausgebildet sein.

Die Energieversorgung bzw. Ansteuerung des Ultraschallwandlers 20 erfolgt beispielhaft über einen Transformator (erster Transformator), der beispielhaft maschinenseitig einen ersten Schalenkern 31 und eine Primärwicklung 32 (Sendereinheit/Senderspule) umfasst (in Fig. 1 nicht gezeigt) und beispielhaft werkzeugseitig einen zweiten Schalenkern 33 und eine Sekundärspule 34 (Empfängereinheit/Empfängerspule) umfasst, die beispielhaft als Ringelemente an der Außenseite des Werkzeughalters 10 angeordnet sind.

Auf einer dem Werkzeugaufnahmeabschnitt 11 abgewandten Seite des Stapels aus ersten Piezo-Elementen 21 ist beispielhaft ein lochscheibenförmiges piezoelektrisches Sensorelement 40 angeordnet, das beispielhaft ein Piezo-Element 41 und zwei Kontakte 42 umfasst und das beispielhaft mechanisch mit den ersten Piezo-Elementen 21 gekoppelt ist, aber durch ein Isolierungselement 43, das aus einer Keramik-Lochscheibe bestehen kann, elektrisch von den ersten Piezo-Elementen 21 isoliert ist. Durch ein weiteres Isolierungselement 43 ist das piezoelektrische Sensorelement 40 beispielhaft von einem Befestigungselement 13, z.B. einer Befestigungsmutter, elektrisch isoliert.

Das Befestigungselement 13 dient der Befestigung des piezoelektrischen Sensorelements 40 am Ultraschallwandler 20 (Ultraschall-Erzeuger/Aktuator) sowie der Vorspannung der ersten Piezo-Elemente 21 wegen der dynamischen Belastung.

Die ersten Piezo-Elemente 21 und das piezoelektrische Sensorelement 40 sind gleich orientiert, wodurch zum einen die Erzeugung und die Detektion der Schwingung in der gleichen Richtung ermöglicht wird und zum Anderen eine platzsparende Anordnung der Elemente im Werkzeughalter 10 (Werkzeugkopf) erreicht wird.

Das piezoelektrische Sensorelement 40 wandelt die mechanischen Schwingungen des schwingungsfähigen Systems, das das Werkzeug 90, den Übertragungsabschnitt 12, den Ultraschallwandler 20 und das piezoelektrische Sensorelement 40 umfasst, in ein Sensorsignal um, das beispielhaft als elektrische Spannung über eine Drahtverbindung 50 von dem piezoelektrischen Sensorelement 40 durch den Werkzeughalter 10 zu einem Senderelement an der Außenseite des Werkzeughalters 10 übertragen wird.

Von dem Senderelement 61 und 62 an einer Bohrung 70 wird das Sensorsignal beispielhaft berührungslos zu einem maschinenseitigen Empfängerelement (in Fig. 1 nicht gezeigt) übertragen.

Das Senderelement 61 und 62 ist z.B. Teil eines weiteren Transformators (zweiter Transformator) und umfasst beispielhaft einen ersten Ferritkern und eine Primärwicklung; das Empfängerelement ist ebenfalls Teil des zweiten Transformators und umfasst einen zweiten Ferritkern und eine Sekundärwicklung. Jedoch ist es auch möglich, ein optisches Senderelement vorzusehen.

Somit kann das Sensorsignal induktiv vom Werkzeughalter 10 zu einer maschinenseitigen Sensorsignal-Auswertevorrichtung übertragen werden.

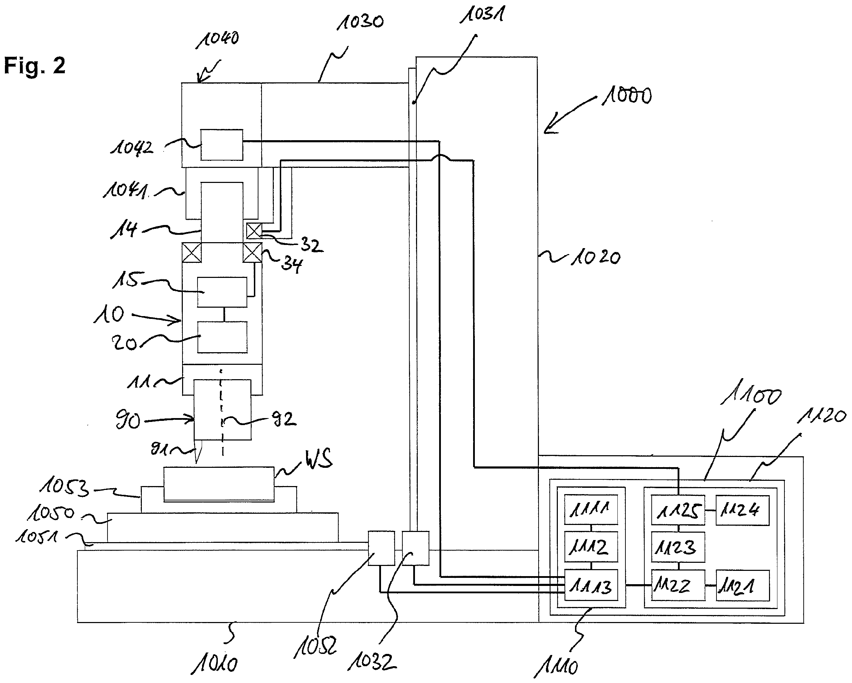

Fig. 2 zeigt beispielhaft eine schematische Darstellung einer Werkzeugmaschine 1000 gemäß einem Ausführungsbeispiel der Erfindung, mit einem Werkzeughalter 10 (Werkzeugkopf), welche in dem erfindungsgemäßen Verfahren gemäß Ausführungsbeispielen eingesetzt werden kann.

Die Werkzeugmaschine 1000 kann z.B. als numerisch steuerbare Fräsmaschine, numerisch steuerbare Universal-Fräsmaschine bzw. als numerisch steuerbares Bearbeitungszentrum ausgebildet sein. Zur Steuerung einer Relativbewegung zwischen Werkzeug und Werkstück kann die Werkzeugmaschine eine Mehrzahl von steuerbaren Linearachsen (in der Regel z.B. X-Achse, Y-Achse und/oder Z-Achse genannt) und/oder eine oder mehrere Rund- bzw. Drehachsen (in der Regel z.B. A-Achse, B-Achse und/oder C-Achse genannt) aufweisen.

Beispielhaft weist die Werkzeugmaschine 1000 in Fig. 2 ein Maschinenbett 1010, einen Maschinenständer 1020 und einen Spindelkopf 1030 auf, wobei das Maschinenbett 1010 beispielhaft einen Werkstücktisch 1050 trägt und der Spindelkopf 1030 beispielhaft eine Arbeitsspindel 1040 trägt.

Der Werkzeugtisch 1050 ist beispielhaft auf horizontalen Linearführungen 1050, die auf dem Maschinenbett 1010 in einer horizontalen Richtung angeordnet sind, in der horizontalen Richtung linear verfahrbar gelagert und ist über einen Linearantrieb 1052 einer ersten Linearachse der Werkzeugmaschine 1000 verfahrbar steuerbar. Auf dem Werkzeugtisch ist beispielhaft ein Werkstück WS in einer Werkstückspanneinrichtung 1053 eingespannt.

Der Spindelkopf 1030 ist beispielhaft auf vertikalen Linearführungen 1050, die an dem Maschinenständer 1020 in einer vertikalen Richtung angeordnet sind, in der vertikalen Richtung linear verfahrbar gelagert und ist über einen Linearantrieb 1032 einer zweiten Linearachse der Werkzeugmaschine 1000 verfahrbar steuerbar, so dass auch die Arbeitsspindel 1040, an der ein ein Werkzeug 90 haltender Werkzeugkopf 10 (Werkzeughalter) aufgenommen ist, vertikal verfahrbar ist.

In weiteren Ausführungsbeispielen können noch ein oder mehr weitere Linearachsen vorgesehen sein, z.B. um zusätzlich eine Linearbewegung des Werkstücks relativ zu dem Werkzeug in einer Richtung senkrecht zur Zeichnungsebene der Fig. 2 zu ermöglichen.

Des Weiteren können ein oder mehrere Dreh- bzw. Rundachsen vorgesehen sein, so z.B. eine Rundachse mit einem Rundachsantrieb zum Rotieren des Werkzeugtisches 1050 (sog. Drehtisch).

Mittels der vorbeschriebenen Linear- und ggf. Rund bzw. Drehachsen bzw. deren Antriebe kann eine Relativbewegung des Werkzeugs 90 relativ zu dem Werkstücks WS gesteuert werden.

Hierzu weist eine Steuervorrichtung 1100 der Werkzeugmaschine 1000 eine Maschinensteuerungseinrichtung 1110 auf, die beispielhaft eine CNC- bzw. NC-Steuerungseinrichtung 1112 umfasst, die dazu eingerichtet ist, z.B. auf Basis von in einer Speichervorrichtung 111 gespeicherten NC-Daten, die Funktionen bzw. Bearbeitungsprozesse an der Werkzeugmaschine 1000 zu steuern. Zudem weist die Maschinensteuerungseinrichtung 1110 beispielhaft eine PLC- bzw. SPS-Einrichtung 1113 auf ("PLC" für Programmable Logic Controller bzw. "SPS" für Speicherprogrammierbare Steuerung).

Die PLC- bzw. SPS-Einrichtung 1113 ist insbesondere bevorzugt dazu eingerichtet, auf Basis von Steuerbefehlen der NC-Steuerungseinrichtung 1112 oder auch ggf. autark von der NC-Steuerungseinrichtung 1112 Steuersignale an Aktoren der Werkzeugmaschine zu übersenden, so z.B. an die Linearantriebe 1052 bzw. 1032 der Linearachsen bzw. generell an Antriebe der Maschinenachsen oder auch an den Spindelantrieb 1042 der Arbeitsspindel 1040.

Zudem ist die PLC- bzw. SPS-Einrichtung 1113 dazu eingerichtet, Sensorsignale von Positionsmesssensoren (nicht gezeigt) der Werkzeugmaschine 1000, die in Echtzeit bei der Bearbeitung gemessene Ist-Positionen der Antriebe und/oder Maschinenachsen angeben, zu empfangen oder auszulesen und ggf. an die NC-Steuerungseinrichtung 1112 weiterzugeben. Die PLC- bzw. SPS-Einrichtung 1113 kann auch dazu eingerichtet sein, anderen maschineninternen oder -externen Einrichtungen bzw. Vorrichtungen zu ermöglichen, Positionsdaten an der PLC- bzw. SPS-Einrichtung 1113 auszulesen, die die Ist-Positionen der Antriebe und/oder Maschinenachsen angeben.

Die Arbeitsspindel 1040 weist neben dem vorstehend bereits erwähnten Spindelantrieb 1042 weiterhin eine Werkzeugaufnahme 1041 (Werkzeugaufnahmeabschnitt) auf, an der der Werkzeugkopf 10 aufgenommen ist und mittels des Spindelantriebs 1042 rotatorisch angetrieben werden kann (insbesondere zur Erzeugung der Schnittbewegung).

Der Werkzeugkopf 10 ist lediglich schematisch dargestellt und weist beispielhaft einen Werkzeugschnittstellenkörper 14 (z.B. ein Werkzeugkegel, bzw. Steil- oder Hohlschaftkegel, oder auch ein Morsekegel oder andere Werkzeugschnittstellen) auf, mit dem der Werkzeugkopf 10 an der Werkzeugaufnahme 1041 der Arbeitsspindel 1040 aufgenommen ist. Beispielweise kann der Werkzeugkopf 10 analog zu Fig. 1 aufgebaut sein. Im Gegensatz zu dem Werkzeughalter 10 des Ausführungsbeispiels gemäß Fig. 1 weist der Werkzeugkopf 10 in Fig. 2 zusätzlich einen später genauer beschriebenen Demodulator 15 auf.

Der Werkzeugkopf 10 weist eine induktive Empfängereinheit 32 (z.B. analog zu der Sekundärspule bzw. -wicklung 34 der Fig. 1) auf zum kontaktlosen bzw. induktiven Empfangen eines Steuersignals von der Sendereinheit 32 (Primärspule bzw. - wicklung), die an dem Spindelkopf (bzw. an der Spindel) angebracht ist.

Erfindungsgemäß weist der Werkzeugkopf 10 in Fig. 2 weiterhin einen Aktuator 20 (z.B. Ultraschallwandler bzw. Ultraschallerzeuger, ggf. beispielhaft umfassend eines oder mehrere Piezoelemente) auf, der dazu eingerichtet ist, auf Basis des Steuersignals den Werkzeugkopf 10 bzw. das in dem Werkzeugkopf 10 aufgenommene Werkzeug 90 in eine Schwingung in Richtung der Werkzeugachse 92 zu versetzen, bevorzugt insbesondere im Ultraschallbereich, d.h. insbesondere bei Ultraschallfrequenzen bzw. bei Frequenzen über 10 kHz bzw. insbesondere z.B. über 15 kHz, z.B. bis zu 60 kHz.

Beispielhaft weist der Werkzeugkopf 10 in Fig. 2 weiterhin einen dem Aktuator 20 vorgeschalteten Demodulator 15 (z.B. ein demodulierender Schaltkreis, ggf. mit einem Microcontroller) auf, der das über die Empfängereinheit 32 empfangene Steuersignal demoduliert bzw. ein niederfrequentes Trägersignal rekonstruiert, mit dem ein hochfrequentes Trägersignal steuervorrichtungsseitig moduliert ist.

Jedoch ist die Erfindung nicht auf Werkzeugköpfe mit Demodulator 15 beschränkt, sondern das modulierte Steuersignal kann auch in anderen Ausführungsbeispielen direkt an den Aktuator eingegeben werden.

Der Werkzeugkopf 10 weist zudem den Werkzeugaufnahmeabschnitt 11 auf, an dem das Fräswerkzeug 90 aufgenommen bzw. gehalten ist. Das Werkzeug 90 weist eine Werkzeugachse 92 auf, um die das Werkzeug über den Spindelantrieb 1042 rotierend angetrieben wird. Die Werkzeugspitze 91 ist beispielhaft durch eine Fräserschneide gebildet, die in axialer Richtung der Werkzeugachse 92 hervorstehend auf einer Außenseite des Fräswerkzeugs 90, d.h. insbesondere von der Werkzeugachse 92 beabstandet, angeordnet ist. Bei rotierendem Antreiben des Werkzeugs 90 rotiert die Frässchneide bzw. Werkzeugspitze 91 um die Werkzeugachse 92 herum.

Zum Antreiben des Aktuators 20 bzw. zum Steuern der Schwingung des Werkzeugs 90 weist die Steuervorrichtung 1100 der Werkzeugmaschine 1000 eine weitere Steuereinrichtung 1120 auf, die das Steuersignal erzeugt und über die Sendereinheit 32 an den Werkzeugkopf 10 zum Übertragen an die Empfängereinrichtung 34 für den Aktuator 20 ausgibt. Die Steuereinrichtung 1120 kann in weiteren Ausführungsbeispielen auch in der Maschinensteuerungseinrichtung 1110 integriert sein und/oder eine externe Datenverarbeitungsvorrichtung, z.B. einen Computer, umfassen bzw. durch eine extern angeschlossene Datenverarbeitungsvorrichtung, z.B. einen Computer, ausgebildet sein.

Die Steuereinrichtung 1120 umfasst beispielhaft einen Generator 1124 zum Erzeugen des hochfrequenten Trägersignals. Das hochfrequente Trägersignal kann z.B. ein im Wesentlichen periodisches bzw. bevorzugt im Wesentlichen sinusförmiges Trägersignal sein, das bevorzugt eine festgelegte Frequenz und/oder eine festgelegte Amplitude aufweist. Die Frequenz des Trägersignals ist hochfrequent (d.h. insbesondere mit einer Frequenz größer 10 kHz, bevorzugt größer 15 kHz) und liegt bevorzugt im Ultraschallbereich.

Die Steuereinrichtung 1120 umfasst beispielhaft weiterhin eine Speichereinrichtung 1121 zum Speichern von Musterdaten, die das auf der Oberfläche des Werkstücks WS aufzubringende Muster bzw. Bild- und/oder Textmuster angeben. Die Musterdaten können hierbei Bilddaten (z.B. eine Bitmap-Graphik speichernde Daten, oder andere Bilddatenformate) darstellen, die das Muster in einem Bilddatenformat angeben.

Alternativ kann die Steuereinrichtung 1120 in der Speichereinrichtung 1121 Musterpositionsdaten speichern, die auf Basis von das Muster angebenden Musterdaten bzw. Bilddaten (z.B. eine Bitmap-Graphik speichernde Daten, oder andere Bilddatenformate) erzeugt sind und bereits eine Position-Bild/Muster-Relation angeben, d.h. Daten, die Positionen auf der Oberfläche des Werkstücks angeben, an denen das Bild- und/oder Textmuster aufzubringen ist, Musterpositionsdaten, die zu einer Mehrzahl von Schneidenpositionen der Werkzeugspitze 91 an der Oberfläche des Werkstücks WS auf Basis des vorgegebenen Musters Auslenkungspositionen angeben (z.B. mit hoher Auslenkung an Positionen des Musters und mit niedriger bzw. keiner Auslenkung an Positionen, an denen kein Muster aufzubringen ist). Dies kann z.B. in Form einer Tabelle vorbereitet und vorgespeichert sein.

Die Steuereinrichtung 1120 umfasst beispielhaft weiterhin eine Datenverarbeitungseirichtung 1122, die dazu eingerichtet ist, die Daten aus der Speichereinrichtung 1121 auszulesen und zudem von der Maschinensteuereinrichtung 1110 Positionen, insbesondere Achsenpositionen, auslesen kann. Dies kann bevorzugt in Echtzeit während der Bearbeitung des Werkstücks WS erfolgen, wobei bevorzugt einerseits aktuelle Ist-Positionen der Achsen und Antriebe der Werkzeugmaschine 1000 z.B. aus der PLC- bzw. SPS-Steuereinrichtung 1113 (und/oder von der NC-Steuerung 1112) in Echtzeit ausgelesen werden können, oder andererseits aktuelle Sollpositionen aus der NC-Steuerung 1112 auslesen kann.

Insbesondere ist die Datenverarbeitungseinrichtung 1122 auf Basis der ausgelesenen Positionsdaten der Maschinensteuerung bevorzugt dazu eingerichtet, die Scheidenposition der Werkzeugspitze 91 des Werkzeugs 90 relativ zu dem Werkstück WS zu berechnen (z.B. auf Basis der berechneten Position der Werkzeugachse 92 auf Basis der Achspositionen der Werkzeugmaschine 1000 und auf Basis der Winkelposition der Arbeitsspindel, insbesondere unter Berücksichtigung des Abstands der Werkzeugspitze zu der Werkzeugachse 92).

Alternativ ist es auch möglich, dass die Position der Werkzeugachse 92 bzw. die Scheidenposition der Werkzeugspitze 91 in der NC-Steuerung 1112 berechnet wird und von der Datenverarbeitungseinrichtung 1122 ausgelesen wird.

Auf Basis der berechneten oder ausgelesenen Scheidenposition der Werkzeugspitze 91 des Werkzeugs 90 relativ zu dem Werkstück WS und im Vergleich mit den das Muster angebenden Daten der Speichervorrichtung 1121 ist die Datenverarbeitungseinrichtung 1122 dazu eingerichtet, eine momentan gewünschte Auslenkung des Werkzeugs 90 auf Grundlage des gewünschten Musters an der aktuellen Schneidenposition zu bestimmen bzw. zu berechnen und an einen Trägersignalerzeuger 1123 als Sollwert abzugeben.

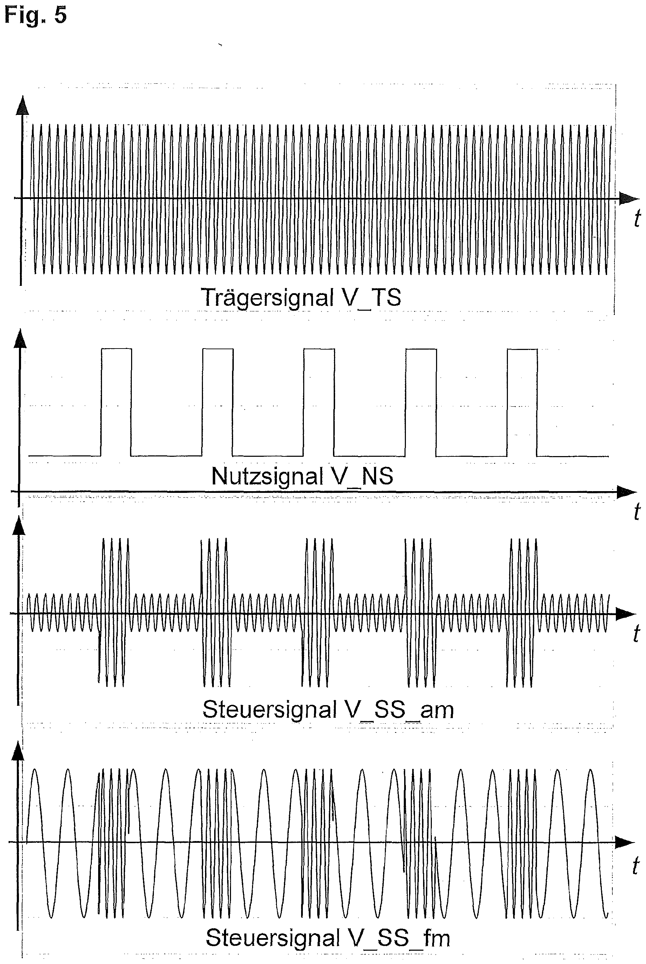

Auf Basis der Berechnungen bzw. Vorgaben der Datenverarbeitungseinrichtung 1122 erzeugt der Nutzsignalerzeuger 1123 ein ggf. kontinuierliches Nutzsignal mit niederfrequent auftretenden Pulsen, insbesondere bei (durchschnittlichen) Frequenzen kleiner 10 kHz und insbesondere bevorzugt kleiner 7 bzw. insbesondere 5 kHz und bevorzugt durchschnittlich größer ca. 1kHz. Die Pulse des Nutzsignals können z.B. rechteckförmig ausgebildet sein (siehe z.B. Fig.5), jedoch können die Pulse des Nutzsignals auch gaußförmig oder entsprechend einer Sinus-Halbwelle ausgebildet sein.

Weiterhin umfasst die Steuereinrichtung 1120 zudem einen Modulator 1125 (bzw. modulierenden Schaltkreis, ggf. mit einem Microcontroller), der dazu eingerichtet ist, das von dem Generator 1124 erzeugte hochfrequente Trägersignal mit dem von dem Nutzsignalerzeuger 1123 erzeugten Nutzsignal zu modulieren und somit auf Grundlage der Träger- und Nutzsignale das modulierte Steuersignal zu erzeugen, dass an den Werkzeugkopf 10 auszugeben ist.

Hierbei ist es möglich, das Trägersignal mit dem Nutzsignal durch Amplitudenmodulation zu modulieren. Jedoch ist es ebenfalls möglich, das Trägersignal mit dem Nutzsignal durch Frequenzmodulation zu modulieren. Auch Kombinationen von Amplituden- und Frequenzmodulation sind möglich. Falls am Werkzeugkopf 10 ein Demodulator 15 vorgesehen ist, kann dort das Nutzsignal rekonstruiert werden, und die Art der Modulation spielt eine nur geringe Rolle.

Falls der Werkzeugkopf 10 jedoch keinen Demodulator umfasst und das modulierte Steuersignal direkt an den Aktuator 20 abgegeben wird, ändert die Art der Modulation die Erscheinung des aufgebrachten Musters. In diesem Falle ist es in Ausführungsbeispielen möglich, dass der Bediener je nach Wunsch und Bedarf selbst einstellen kann, ob eine Amplituden- oder Frequenzmodulation bzw. deren Kombination angewendet werden soll.

Einerseits kann bei Ausführungsbeispielen ohne Demodulator am Werkzeugkopf das Trägersignal mit dem Nutzsignal durch Amplitudenmodulation moduliert. Werden. Dies führt z.B. dazu, dass zu Zeiten eines Pulses des Nutzsignals eine höhere Auslenkung des Aktuators 20 aufgrund der höheren Amplitude erzeugt wird. Somit sind die Einschläge der Werkzeugschneide der Werkzeugspitze 91 zu Zeiten eines Pulses des Nutzsignals bei gleichbleibender Frequenz des Trägersignals tiefer in der Oberfläche des Werkstücks 90 (höhere Eindringtiefe bei Puls des Nutzsignals), so dass das Muster auf der Oberfläche durch Tiefen und Höhen in der Oberflächenstrukturierung erzeugt werden kann.

Jedoch ist es ebenfalls möglich, bei Ausführungsbeispielen ohne Demodulator am Werkzeugkopf das Trägersignal mit dem Nutzsignal durch Frequenzmodulation zu modulieren. Dies führt z.B. dazu, dass zu Zeiten eines Pulses des Nutzsignals bei gleichbleibender Amplitude eine andere (bevorzugt höhere) Frequenz des Aktuators 20 aufgrund der höheren Frequenz des Steuersignals erzeugt wird. Somit sind die Einschläge der Werkzeugschneide der Werkzeugspitze 91 bei gleichbleibender Amplitude der Auslenkung gleich Tief aber bei unterschiedlichen Frequenzen (z.B. höhere Frequenz bei Puls des Nutzsignals), so dass an der Oberfläche des Werkstücks 90 das Muster auf der Oberfläche durch unterschiedliche Schattierungen in der Oberflächenstrukturierung erzeugt werden kann.

Ebenso ist es möglich, bei Ausführungsbeispielen ohne Demodulator am Werkzeugkopf das Trägersignal mit dem Nutzsignal durch Amplituden- und Frequenzmodulation zu modulieren. Dies führt z.B. dazu, dass zu Zeiten eines Pulses des Nutzsignals eine höhere Frequenz des Aktuators 20 aufgrund der höheren Frequenz des Steuersignals erzeugt wird und zudem zu Zeiten eines Pulses des Nutzsignals eine höhere Auslenkung des Aktuators 20 aufgrund der höheren Amplitude erzeugt wird. Somit sind die Einschläge der Werkzeugschneide der Werkzeugspitze 91 zu Zeiten eines Pulses des Nutzsignals tiefer in der Oberfläche des Werkstücks 90 (höhere Eindringtiefe bei Puls des Nutzsignals) und sind die Einschläge der Werkzeugschneide der Werkzeugspitze 91 bei unterschiedlicher Frequenz (z.B. höhere Frequenz bei Puls des Nutzsignals), so dass das Muster auf der Oberfläche durch Tiefen und Höhen und durch unterschiedliche Schattierungen in der Oberflächenstrukturierung erzeugt werden kann.

Fig. 5 zeigt beispielhaft Beispiele eines Trägersignals, eines Nutzsignals, eines amplitudenmodulierten Steuersignals und eines frequenzmodulierten Steuersignals gemäß Ausführungsbeispielen.

Hierbei sind beispielhaft ein hochfrequentes sinusförmiges Trägersignal V_TS und ein (lediglich beispielhaft) periodisches Nutzsignal V_NS mit beispielhaft rechteckigen Pulsen gezeigt. Es sei darauf hingewiesen, dass das Nutzsignal V_NS in der Regel nicht periodisch auftretende Pulse gleicher Pulsbreite aufweist, da die Pulsfrequenz und Pulsbreite individuell in Abhängigkeit des jeweiligen Musters variiert.

Beispielhaft zeigt Fig. 5 weiterhin Steuersignale, die durch Modulation des Trägersignals V_TS auf Basis des Nutzsignals V_NS erzeugt werden können, nämlich beispielhaft das amplitudenmodulierte Steuersignal V_SS_am und das frequenzmodulierte Steuersignal V_SS_fm.

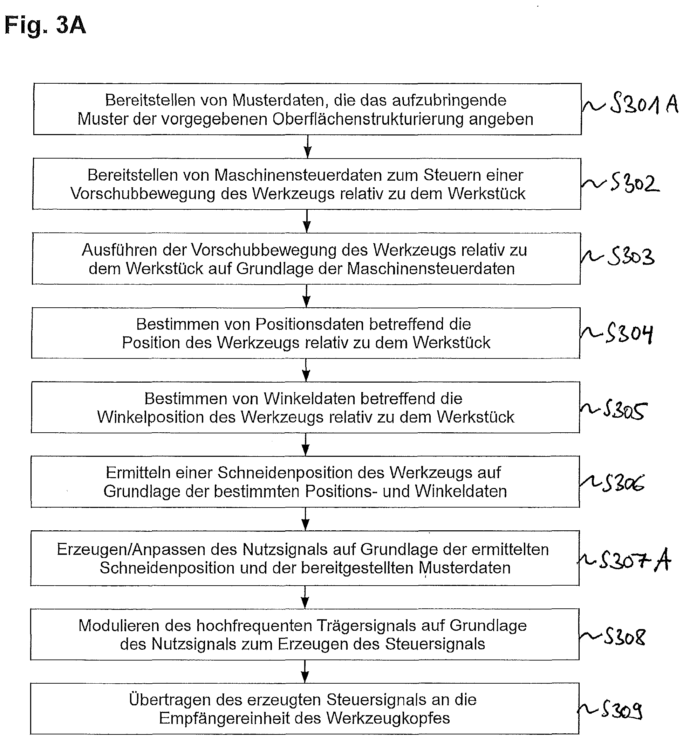

Fig. 3A zeigt beispielhaft ein Ablaufdiagramm eines Verfahrens des Übertragens eines Steuersignals in einem Verfahren zum Aufbringen einer Oberflächenstrukturierung auf eine Oberfläche eines Werkstücks WS an einer Werkzeugmaschine 1000 gemäß einem Ausführungsbeispiel.

In Schritt S301A werden Musterdaten bereitgestellt, die das aufzubringende Muster der vorgegebenen Oberflächenstrukturierung angeben. Dies können z.B. Bilddaten sein, die das aufzubringende Text- und/oder Bildmuster angeben (z.B. Bitmap-Graphikdaten oder Bilddaten in einem anderen Bilddatenformat, z.B. als JPEG-Datei).

Im Schritt S302 werden Maschinensteuerdaten zum Steuern der Vorschubbewegung des Werkzeugs 90 relativ zu dem Werkstück WS bereitgestellt. Dies kann z.B. NC-Daten (z.B. ein oder mehrere NC-Programme) umfassen, die eine Vorschubbewegung des Werkzeugs entlang der Oberfläche des Werkstücks WS beschreiben, z.B. zum Durchführen eines Planfräsprozesses über die Oberfläche des Werkstücks WS. Falls das Werkstück eine Freiformfläche aufweist, wird an der Freiformfläche das Werkstück WS bevorzugt derart bearbeitet, dass die Maschinensteuerdaten eine Vorschubbewegung angeben, bei der die Werkzeugachse 92 stets in jedem Moment koaxial mit dem jeweiligen (die Orientierung ändernden) Normalenvektor des Werkstücks WS ausgerichtet ist. Bei einer ebenen Werkstückoberfläche an der Stelle des aufzubringenden Musters werden die Vorschubbewegungen bevorzugt mit gleichbleibender Orientierung der Werkzeugachse 92 senkrecht zur Werkstückoberfläche ausgeführt.

Im Schritt S303 wird durch die Maschinensteuerung 1110 auf Basis der Maschinensteuerdaten die Vorschubbewegung des Werkzeugs 90 relativ zu dem Werkstück WS durchgeführt.

Während der Bearbeitung und der ausgeführten Vorschubbewegung werden im Schritt S304 in Echtzeit jeweils aktuelle Positionsdaten bestimmt (siehe oben), die direkt oder indirekt (d.h. z.B. nach Berechnung aus den Positionsdaten) die Position der Werkzeugachse 92 des Werkzeugs 90 bzw. die Position des Werkzeugs 90 angeben.

Im Schritt S305 werden gleichzeitig zu Schritt S305 Winkeldaten bestimmt, die direkt oder indirekt (d.h. z.B. nach Berechnung aus den Winkeldaten) die Winkelposition des Werkzeugs 90 bzw. der Werkzeugspitze 91 angeben.

Im Schritt S306 wird die aktuelle Schneidenposition der Werkzeugspitze 91 des Werkzeugs 90 auf Grundlage der Positions- und Winkeldaten bestimmt bzw. berechnet. Somit ist die Position der Werkzeugspitze 91 des Werkzeugs 90 über der Oberfläche des Werkstücks in diesem Zeitpunkt bekannt.

Auf Basis der ermittelten aktuelle Schneidenposition der Werkzeugspitze 91 des Werkzeugs 90 wird in Schritt S307A auf Basis der vorgegebenen Musterdaten das entsprechende Nutzsignal erzeugt, insbesondere z.B. derart, dass das Nutzsignal an Positionen des Musters (bzw. wenn die Werkzeugspitze sich an einer Position des Musters befindet) einen Auslenkungspuls bzw. Puls (eine höhere bzw. hohe Amplitude) aufweist und an anderen Positionen (bzw. wenn die Werkzeugspitze sich nicht an einer Position des Musters befindet) keinen Auslenkungspuls bzw. Puls (d.h. eine niedrigere bzw. niedrige Amplitude) aufweist.

Im Schritt S308 wird das hochfrequente Trägersignal mit dem Nutzsignal moduliert und das modulierte Steuersignal erzeugt, welches dann in Schritt S309 an die Empfängereinheit 34 des Werkzeugkopfes 10 übertragen wird.

Im vorstehenden Beispiel wird in Schritt S307A in Echtzeit auf Basis der Musterdaten (z.B. Bilddaten bzw. Bitmap-Bilddaten) das Nutzsignal erzeugt. In weiteren Ausführungsbeispielen kann z.B. vor der Bearbeitung eine andere Art von Daten erzeugt werden, die auf Basis von Musterdaten (z.B. Bilddaten bzw. Bitmap-Bilddaten) erzeugt werden und Positionen auf der Werkzeugoberfläche (z.B. im Werkzeugmaschinenkoordinatensystem) angeben, an denen das Muster aufzubringen ist. Dies kann z.B. eine Tabelle sein. Insbesondere können dies Daten (Musterpositionsdaten) sein, die auf Basis von Bilddaten erzeugt werden und Positionen des Musters (z.B. Pixelpositionen) auf der Oberfläche des Werkstücks WS im Werkstück- und/oder Werkzeugmaschinenkoordinatensystem angeben.

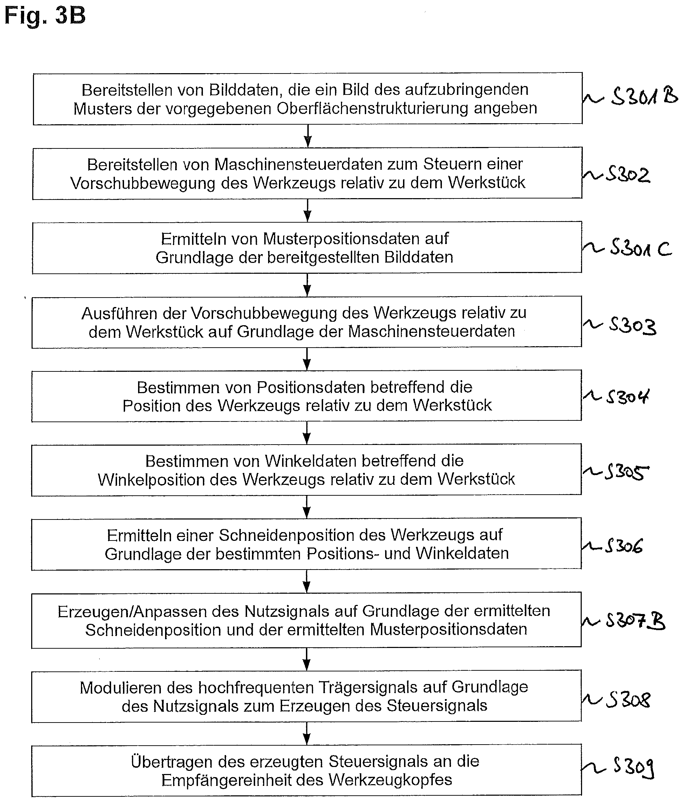

Fig. 3B zeigt beispielhaft ein Ablaufdiagramm eines Verfahrens des Übertragens eines Steuersignals in einem Verfahren zum Aufbringen einer Oberflächenstrukturierung auf eine Oberfläche eines Werkstücks an einer Werkzeugmaschine gemäß einem weiteren Ausführungsbeispiel.

In Schritt 301B werden Bilddaten bereitgestellt, die das Muster in einem Bilddatenformat angeben, und diese werden in Schritt S301C nicht mehr im, sondern beispielhaft vor dem eigentlichen Bearbeitungsverfahren in Musterpositionsdaten umgerechnet, bzw. es werden auf Grundlager der Bilddaten Musterpositionsdaten ermittelt, die z.B. Positionen des Musters auf der Oberfläche des Werkstücks WS (z.B. im Werkstück- und/oder Werkzeugmaschinenkoordinatensystem) angeben.

Im Schritt S307B werden dann in Echtzeit bei der Bearbeitung des Werkstücks auf Grundlage der ermittelten Musterpositionsdaten und der ermittelten Schneidenposition das Nutzsignal erzeugt bzw. angepasst. Dies ermöglicht ggf. eine schnellere und effizientere Datenbearbeitung in Echtzeit, da vor Beginn des Bearbeitungsverfahren (z.B. ab S303) bereits vereinfacht nutzbare Musterpositionsdaten erzeugt bzw. ermittelt werden.

Die anderen Schritte S302, S303, S304, S305, S306, S308 und S309 können analog zu Fig. 3A durchgeführt werden.

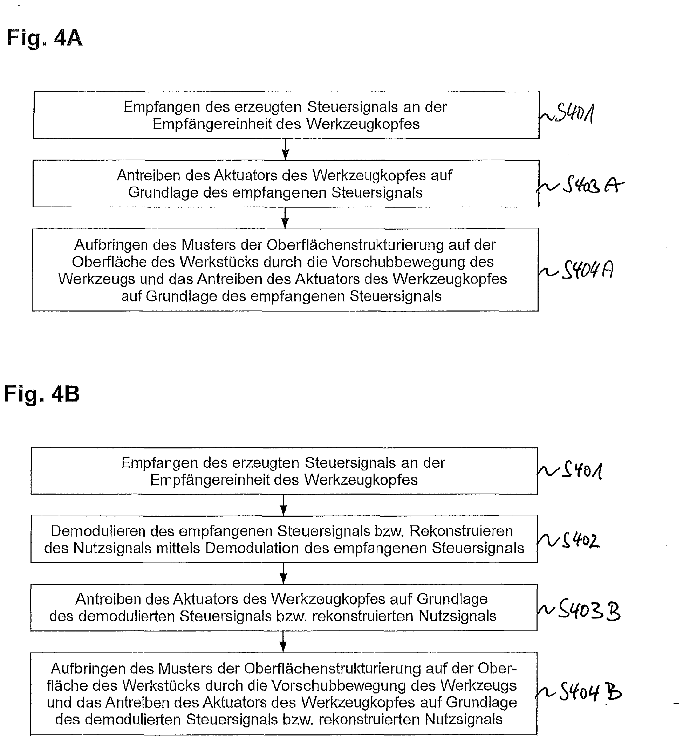

Fig. 4A zeigt beispielhaft ein Ablaufdiagramm eines Verfahrens des Empfangens eines Steuersignals und Aufbringen einer Oberflächenstrukturierung auf eine Oberfläche eines Werkstücks an einer Werkzeugmaschine gemäß einem Ausführungsbeispiel.

Im Schritt S401 wird das in Schritt S309 (gemäß Fig. 3A oder Fig. 3B) übertragene Steuersignal an der Empfängereinheit 34 des Werkzeugkopfes 10 empfangen (z.B. induktiv) und in Schritt S403A beispielhaft direkt an den Aktuator 20 abgegeben, so dass der Aktuator auf Grundlage des empfangenen Steuersignals gesteuert wird.

Somit wird beispielhaft das Muster der Oberflächenstrukturierung auf der Oberfläche des Werkstücks in Schritt S404A durch die gesteuerte Vorschubbewegung (Schritt S303) und das Antreiben des Aktuators 20 (S403A) auf Grundlage des empfangenen (modulierten) Steuersignals aufgebracht.

Fig. 4B zeigt beispielhaft ein Ablaufdiagramm eines Verfahrens des Empfangens eines Steuersignals und Aufbringen einer Oberflächenstrukturierung auf eine Oberfläche eines Werkstücks an einer Werkzeugmaschine gemäß einem weiteren Ausführungsbeispiel.

Im Schritt S401 wird das in Schritt S309 (gemäß Fig. 3A oder Fig. 3B) übertragene Steuersignal an der Empfängereinheit 34 des Werkzeugkopfes 10 empfangen (z.B. induktiv) und in Schritt S402 am Demodulator 15 des Werkzeugkopfes 10 demoduliert, insbesondere zur Rekonstruktion des Nutzsignals aus dem modulierten Steuersignal.

Das demodulierte Steuersignal bzw. das rekonstruierte Nutzsignal wird in S403B beispielhaft an den Aktuator 20 abgegeben, so dass der Aktuator auf Grundlage des demodulierten Steuersignals bzw. des rekonstruierten Nutzsignals gesteuert wird.

Somit wird beispielhaft das Muster der Oberflächenstrukturierung auf der Oberfläche des Werkstücks in Schritt S404B durch die gesteuerte Vorschubbewegung (Schritt S303) und das Antreiben des Aktuators 20 (S403B) auf Grundlage des demodulierten Steuersignals bzw. des rekonstruierten Nutzsignals aufgebracht.

Vorstehend wurden Beispiele bzw. Ausführungsbeispiele der vorliegenden Erfindung sowie deren Vorteile detailliert unter Bezugnahme auf die beigefügten Figuren beschrieben.

Es sei erneut hervorgehoben, dass die vorliegende Erfindung jedoch in keinster Weise auf die vorstehend beschriebenen Ausführungsbeispiele und deren Ausführungsmerkmale begrenzt bzw. eingeschränkt ist, sondern weiterhin Modifikationen der Ausführungsbeispiele umfasst, insbesondere diejenigen, die durch Modifikationen der Merkmale der beschriebenen Beispiele bzw. durch Kombination einzelner oder mehrerer der Merkmale der beschriebenen Beispiele im Rahmen des Schutzumfanges der unabhängigen Ansprüche umfasst sind.

## Patentansprüche

1. Verfahren zum Aufbringen einer Oberflächenstrukturierung auf eine Oberfläche eines Werkstücks (WS) entsprechend eines vorgesehenen Bild- und/oder Textmusters an einer Werkzeugmaschine (1000), umfassend:
Ausführen einer Vorschubbewegung eines von einer Arbeitsspindel (1040) der Werkzeugmaschine (1000) rotierend angetriebenen und in einem Werkzeugkopf (10) der Werkzeugmaschine (1000) aufgenommenen Fräswerkzeugs mit zumindest einer vorstehenden Schneide entlang der Oberfläche des Werkstücks (WS),
Aufbringen der Oberflächenstrukturierung entsprechend des vorgegebenen Bild- und/oder Textmusters auf die Oberfläche des Werkstücks (WS) während der Vorschubbewegung des Fräswerkzeugs auf Grundlage eines Steuersignals an einen in dem Werkzeugkopf (10) integrierten Aktuator (20), der dazu eingerichtet ist, auf Grundlage des Steuersignals eine Schwingung des Fräswerkzeugs anzutreiben,
wobei der Aktuator (20) dazu eingerichtet ist, eine Schwingung in axialer Richtung des Fräswerkzeugs anzutreiben, und
eine axiale Richtung des Werkzeugs während der Vorschubbewegung entlang der Oberfläche des Werkstücks (WS) parallel zu einem Normalenvektor der Oberfläche des Werkstücks (WS) orientiert wird,
**dadurch gekennzeichnet, dass**:
das zur Oberflächenstrukturierung genutzte Bild- und/oder Textmuster, zur Angabe von Positionen des Musters auf der Oberfläche des Werkstücks (WS), vor dem Bearbeitungsverfahren in Musterpositionsdaten umgerechnet wird,
das Steuersignal ein hochfrequentes Trägersignal und ein das Trägersignal modulierendes Nutzsignal, das auf Grundlage von das vorgegebene Bild- und/oder Textmuster angebenden Musterpositionsdaten erzeugt wird, umfasst,
das Steuersignal induktiv von einer als Sendereinheit an der Arbeitsspindel (1040) angeordneten Primärspule (32) zu einer als Empfängereinheit am Werkzeugkopf (10) angeordneten Sekundärspule (34) übertragen wird.

2. Verfahren gemäß Anspruch 1, **dadurch gekennzeichnet, dass** die das vorgegebene Muster angebenden Daten Bilddaten, insbesondere Bitmap-Bilddaten, umfassen.

3. Verfahren gemäß Anspruch 1, oder 2, **dadurch gekennzeichnet, dass**
der Aktuator (20) auf Basis des modulierten Steuersignals angetrieben wird; oder dass
der Aktuator (20) nach Demodulation des Steuersignals auf Basis des Nutzsignals angetrieben wird.

4. Verfahren gemäß einem der vorstehenden Ansprüche, **dadurch gekennzeichnet, dass** das hochfrequente Trägersignal auf Basis des Nutzsignals amplitudenmoduliert ist.

5. Verfahren gemäß einem der vorstehenden Ansprüche, **dadurch gekennzeichnet, dass** das hochfrequente Trägersignal auf Basis des Nutzsignals frequenzmoduliert ist.

6. Verfahren gemäß einem der vorstehenden Ansprüche, **dadurch gekennzeichnet, dass** das Trägersignal eine Frequenz im Ultraschallbereich aufweist.

7. Verfahren gemäß Anspruch 5 und Anspruch 1, **dadurch gekennzeichnet, dass** die Oberflächenstrukturierung ein dem vorgegebenen Muster entsprechendes Muster aufweist.

8. Verfahren gemäß einem der vorstehenden Ansprüche, **dadurch gekennzeichnet, dass** der Aktuator (20) ein oder mehrere Piezoelemente umfasst.

9. Verfahren gemäß einem der vorstehenden Ansprüche, **dadurch gekennzeichnet, dass** das Werkzeug während der Vorschubbewegung entlang der Oberfläche des Werkstücks (WS) senkrecht zu einem Normalenvektor der Oberfläche des Werkstücks (WS) verfahren wird.

10. Werkzeugmaschine (1000), umfassend:
eine Steuervorrichtung (1100) zum Steuern der Werkzeugmaschine (1000), mit
einer Speichereinrichtung (1121) eingerichtet zum Speichern von das vorgegebene Bild- und/oder Textmuster angebenden Musterpositionsdaten und/oder einer Empfangseinrichtung zum Empfangen von das vorgegebene Bild- und/oder Textmuster angebenden Musterpositionsdaten, und
einer Steuersignalerzeugungseinrichtung (1123) eingerichtet zum Erzeugen des Steuersignals mit dem hochfrequenten Trägersignal und dem das Trägersignal modulierenden Nutzsignals, das auf Grundlage der das vorgegebene Bild- und/oder Textmuster angebenden Musterpositionsdaten erzeugt wird;
eine Arbeitsspindel (1040) mit einem Werkzeugkopf (10), der dazu eingerichtet ist, ein Fräswerkzeugs mit zumindest einer vorstehenden Schneide aufzunehmen, und
einem in dem Werkzeugkopf (10) integrierten Aktuator (20), der dazu eingerichtet ist, auf Grundlage eines Steuersignals der Steuervorrichtung (1100) eine Schwingung des aufgenommenen Fräswerkzeugs anzutreiben, **dadurch gekennzeichnet, dass**:
das zur Oberflächenstrukturierung genutzte Bild- und/oder Textmuster, zur Angabe von Positionen des Musters auf der Oberfläche des Werkstücks (WS), vor dem Bearbeitungsverfahren in die Musterpositionsdaten umgerechnet wird
die Arbeitsspindel (1040) eine Primärspule (32) als Sendereinheit aufweist,
der Werkzeugkopf (10) eine Sekundärspule (34) als Empfängereinheit aufweist, und
die Steuervorrichtung (1100) eingerichtet ist, ein Verfahren nach einem der vorstehenden Ansprüche auszuführen.

11. Computerprogrammprodukt mit einem auf einem computerlesbaren Datenspeichermedium gespeicherten Computerprogramm, das ausführbar an einer numerischen Steuervorrichtung (1100) einer numerisch gesteuerten Werkzeugmaschine (1000) gemäß Anspruch 10 oder in einem mit einer Steuervorrichtung (1100) einer numerisch gesteuerten Werkzeugmaschine (1000) gemäß Anspruch 10 verbundenen Computer ist, und das dazu eingerichtet ist, an der Werkzeugmaschine (1000) gemäß Anspruch 10 ein Verfahren gemäß einem der Ansprüche 1 bis 9 zu steuern.

## Claims

1. Method for applying a surface structuring to a surface of a workpiece (WS) in accordance with a predetermined image and/or text pattern on a machine tool (1000), comprising:
carrying out a feed movement of a milling tool driven in rotation by a work spindle (1040) of the machine tool (1000) and received in a tool head (10) of the machine tool (1000) with at least one protruding cutting edge along the surface of the workpiece (WS),
applying the surface structuring in accordance with the predetermined image and/or text pattern to the surface of the workpiece (WS) during the feed movement of the milling tool on the basis of a control signal to an actuator (20) integrated in the tool head (10), which is configured to drive an oscillation of the milling tool on the basis of the control signal,
wherein the actuator (20) is configured to drive an oscillation in the axial direction of the milling tool, and
an axial direction of the tool during the feed movement along the surface of the workpiece (WS) is oriented parallel to a normal vector of the surface of the workpiece (WS),
**characterised in that**:
the image and/or text pattern used for the surface structuring, for indicating positions of the pattern on the surface of the workpiece (WS), is converted into pattern position data before the machining method,
the control signal comprises a high-frequency carrier signal and a useful signal modulating the carrier signal, which is generated on the basis of pattern position data indicating the predetermined image and/or text pattern,
the control signal is transmitted inductively from a primary coil (32) arranged as a transmitter unit on the work spindle (1040) to a secondary coil (34) arranged as a receiver unit on the tool head (10).

2. Method according to claim 1, **characterised in that** the data indicating the predetermined pattern comprise image data, in particular bitmap image data.

3. Method according to claim 1 or 2, **characterised in that**
the actuator (20) is driven on the basis of the modulated control signal; or **in that**
the actuator (20) is driven after demodulation of the control signal on the basis of the useful signal.

4. Method according to one of the preceding claims, **characterised in that** the high-frequency carrier signal is amplitude-modulated on the basis of the useful signal.

5. Method according to one of the preceding claims, **characterised in that** the high-frequency carrier signal is frequency-modulated on the basis of the useful signal.

6. Method according to one of the preceding claims, **characterised in that** the carrier signal has a frequency in the ultrasonic range.

7. Method according to claim 5 and claim 1, **characterised in that** the surface structuring has a pattern corresponding to the predetermined pattern.

8. Method according to one of the preceding claims, **characterised in that** the actuator (20) comprises one or more piezo elements.

9. Method according to one of the preceding claims, **characterised in that** the tool during the feed movement along the surface of the workpiece (WS) is moved perpendicular to a normal vector of the surface of the workpiece (WS).

10. Machine tool (1000), comprising:
a control device (1100) for controlling the machine tool (1000), having
a storage device (1121) configured to store pattern position data indicating the predetermined image and/or text pattern and/or a receiving device for receiving pattern position data indicating the predetermined image and/or text pattern, and
a control signal generating device (1123) configured to generate the control signal with the high-frequency carrier signal and the useful signal modulating the carrier signal, which is generated on the basis of the pattern position data indicating the predetermined image and/or text pattern;
a work spindle (1040) having a tool head (10) which is configured to receive a milling tool with at least one protruding cutting edge, and
an actuator (20) integrated in the tool head (10), which is configured to drive an oscillation of the received milling tool on the basis of a control signal of the control device (1100), **characterised in that**:
the image and/or text pattern used for the surface structuring, for indicating positions of the pattern on the surface of the workpiece (WS), is converted into the pattern position data before the machining method,
the work spindle (1040) has a primary coil (32) as a transmitter unit,
the tool head (10) has a secondary coil (34) as a receiver unit, and
the control device (1100) is configured to carry out a method according to one of the preceding claims.

11. Computer program product having a computer program stored on a computer-readable data storage medium, which can be executed on a numerical control device (1100) of a numerically controlled machine tool (1000) according to claim 10 or in a computer connected to a control device (1100) of a numerically controlled machine tool (1000) according to claim 10, and which is configured to control a method according to one of claims 1 to 9 on the machine tool (1000) according to claim 10.

## Revendications

1. Procédé d'application d'une structuration de surface sur une surface d'une pièce (WS) conformément à un motif d'image et/ou de texte prévu sur une machine-outil (1000), comprenant :
la réalisation d'un mouvement d'avance d'un outil de fraisage entraîné en rotation par une broche de travail (1040) de la machine-outil (1000) et reçu dans une tête d'outil (10) de la machine-outil (1000) avec au moins un tranchant en saillie le long de la surface de la pièce (WS),
l'application de la structuration de surface conformément au motif d'image et/ou de texte prédéfini sur la surface de la pièce (WS) pendant le mouvement d'avance de l'outil de fraisage sur la base d'un signal de commande à un actionneur (20) intégré dans la tête d'outil (10), qui est conçu pour entraîner une oscillation de l'outil de fraisage sur la base du signal de commande,
dans lequel l'actionneur (20) est conçu pour entraîner une oscillation dans la direction axiale de l'outil de fraisage, et
une direction axiale de l'outil pendant le mouvement d'avance le long de la surface de la pièce (WS) est orientée parallèlement à un vecteur normal de la surface de la pièce (WS),
**caractérisé en ce que** :
le motif d'image et/ou de texte utilisé pour la structuration de surface, pour indiquer des positions du motif sur la surface de la pièce (WS), est converti en données de position de motif avant le procédé d'usinage,
le signal de commande comprend un signal porteur haute fréquence et un signal utile modulant le signal porteur, qui est généré sur la base de données de position de motif indiquant le motif d'image et/ou de texte prédéfini,
le signal de commande est transmis par induction d'une bobine primaire (32) disposée en tant qu'unité émettrice sur la broche de travail (1040) à une bobine secondaire (34) disposée en tant qu'unité réceptrice sur la tête d'outil (10).

2. Procédé selon la revendication 1, **caractérisé en ce que** les données indiquant le motif prédéfini comprennent des données d'image, en particulier des données d'image bitmap.

3. Procédé selon la revendication 1 ou 2, **caractérisé en ce que**
l'actionneur (20) est entraîné sur la base du signal de commande modulé ; ou **en ce que**
l'actionneur (20) est entraîné après démodulation du signal de commande sur la base du signal utile.

4. Procédé selon l'une des revendications précédentes, **caractérisé en ce que** le signal porteur haute fréquence est modulé en amplitude sur la base du signal utile.

5. Procédé selon l'une des revendications précédentes, **caractérisé en ce que** le signal porteur haute fréquence est modulé en fréquence sur la base du signal utile.

6. Procédé selon l'une des revendications précédentes, **caractérisé en ce que** le signal porteur présente une fréquence dans le domaine des ultrasons.

7. Procédé selon la revendication 5 et la revendication 1, **caractérisé en ce que** la structuration de surface présente un motif correspondant au motif prédéfini.

8. Procédé selon l'une des revendications précédentes, **caractérisé en ce que** l'actionneur (20) comprend un ou plusieurs éléments piézoélectriques.

9. Procédé selon l'une des revendications précédentes, **caractérisé en ce que** l'outil pendant le mouvement d'avance le long de la surface de la pièce (WS) est déplacé perpendiculairement à un vecteur normal de la surface de la pièce (WS).

10. Machine-outil (1000), comprenant :
un dispositif de commande (1100) pour commander la machine-outil (1000), avec
un dispositif de stockage (1121) conçu pour stocker des données de position de motif indiquant le motif d'image et/ou de texte prédéfini et/ou un dispositif de réception pour recevoir des données de position de motif indiquant le motif d'image et/ou de texte prédéfini, et
un dispositif de génération de signal de commande (1123) conçu pour générer le signal de commande avec le signal porteur haute fréquence et le signal utile modulant le signal porteur, qui est généré sur la base des données de position de motif indiquant le motif d'image et/ou de texte prédéfini ;
une broche de travail (1040) avec une tête d'outil (10) qui est conçue pour recevoir un outil de fraisage avec au moins un tranchant en saillie, et
un actionneur (20) intégré dans la tête d'outil (10), qui est conçu pour entraîner une oscillation de l'outil de fraisage reçu sur la base d'un signal de commande du dispositif de commande (1100), **caractérisé en ce que** :
le motif d'image et/ou de texte utilisé pour la structuration de surface, pour indiquer des positions du motif sur la surface de la pièce (WS), est converti en données de position de motif avant le procédé d'usinage,
la broche de travail (1040) présente une bobine primaire (32) en tant qu'unité émettrice,
la tête d'outil (10) présente une bobine secondaire (34) en tant qu'unité réceptrice, et
le dispositif de commande (1100) est conçu pour exécuter un procédé selon l'une des revendications précédentes.

11. Produit de programme informatique avec un programme informatique stocké sur un support de stockage de données lisible par ordinateur, qui peut être exécuté sur un dispositif de commande numérique (1100) d'une machine-outil à commande numérique (1000) selon la revendication 10 ou dans un ordinateur relié à un dispositif de commande (1100) d'une machine-outil à commande numérique (1000) selon la revendication 10, et qui est conçu pour commander un procédé selon l'une des revendications 1 à 9 sur la machine-outil (1000) selon la revendication 10.
